# EUROPEAN PATENT APPLICATION

(11) **EP 1 930 173 A1**
(43) Date of publication of application: **11.06.2008**
(21) Application number: 06810763.0
(22) Date of filing: 28.09.2006
(51) Int. Cl.: B41N 1/22, B41C 1/02, B41N 1/12, G02B 5/20, G03F 7/00, G03F 7/09

(54) **PHOTOGRAVURE ENGRAVING ROLL WITH CUSHIONING LAYER AND PRODUCTION METHOD THEREFOR**

(30) Priority: 30.09.2005 JP 2005288258
(71) Applicant: THINK LABORATORY CO., LTD., Chiba, 227-8525 (JP)
(72) Inventor: SHIGETA, Tatsuo, Kashiwa-shi Chiba 277-8525 (JP); SATO, Tsutomu, Kashiwa-shi Chiba 277-8525 (JP); SUGIYAMA, Koichi, Yokohama-shi Kanagawa 220-8109 (JP); ASANO, Takayuki, Tokyo 146-0093 (JP)
(74) Representative: Grünecker, Kinkeldey, Stockmair & Schwanhäusser Anwaltssozietät
(86) International application number: PCT/JP2006/319316
(87) International publication number: WO 2007/040140

(57) **Abstract**

Provided is a method of producing a printing plate, especially a gravure plate with cushion properties, which enables direct gravure printing on a hard printing target without using a blanket roll owing to being provided with cushion properties, effects a satisfactory gravure printing on a rough surface such as corrugated cardboard, and is suitable for color-printing a matrix image for forming a color filter on glass for liquid crystal panels or an image on a compact disk or the like. The gravure plate includes a hollow roll provided on the surface thereof with a cushion layer formed of rubber or resin with cushion properties, a copper-plated layer formed on the surface of the cushion layer and formed on the surface thereof with multiple gravure cells, a metal layer formed on the surface of the copper-plated layer, a metal carbide layer formed on the surface of the metal layer, and a diamond-like carbon film for covering the surface of the metal carbide layer.

## Description

### Technical Field

The present invention relates to a gravure printing roll having a cushion layer suitable for printing on the rough surface of corrugated cardboard or the like, printing an image on a compact disk or the like, or color-printing a matrix image for forming a color filter on glass for liquid crystal panels, and a method of producing the same. More particularly, the present invention relates to a gravure printing roll having a cushion layer, in which a diamond-like carbon (DLC) film layer is provided as a surface-reinforcing coating layer, and a method of producing the same.

### Background Art

Conventionally, in order to color-print a matrix image for forming a color filter on a printing plate, especially, glass for liquid crystal panels or color-print an image on a compact disk or the like, gravure offset printing or dry offset printing has been adopted, and gravure printing has not been adopted. This is because the gravure printing may cause breakage of glass, distortion of a compact disc, etc., due to no cushion properties when printing pressure increases. Therefore, in the case where the printing pressure increases, the gravure offset printing, in which printing is performed through a blanket roll formed of rubber, is suitable because the increase in the printing pressure can be controlled due to deformation of the rubber.

In order to color-print an image on glass for a liquid crystal panel, it is necessary to uniformly transmit backlight and to secure a high transmission rate while adjusting the film thickness of wet ink immediately after transferred to glass to be uniform and 5 to 6 µm and the film thickness of dry ink to be uniform and 1 to 1.5 µm. In order to color-print an image on a compact disc or the like, it is necessary to reduce the film thickness of ink as much as possible to a grade where a sharp image is obtained. This is because it is found that since the image to be printed on a compact disc or the like is disproportionately printed with respect to the center, the weight of ink which forms the image cannot be ignored as a cause of imbalanced revolution, which occurs accompanied with increased revolution rate of a spindle motor employing a fluid dynamic bearing of the next-generation compact disc apparatus.

The conventional gravure printing plates need to form cells so that the depths thereof are 15 to 25 µm on a surface portion of a copper-plated layer. Thus, the film thickness of wet ink is 15 to 25 µm, which is too thick and is not suitable for color-printing an image on glass for liquid crystal panels or color-printing an image on a compact disc or the like.

In the conventional gravure printing plates, cells cannot be formed by etching on the surface portion of the copper-plated layer so that the depths thereof are 5 to 6 µm because the etching is not uniformly progressed due to the crystalline structure of the copper-plated layer. It is inevitable that irregularities are formed on the profiles and the bottom surfaces of the cells or cells whose depths are different according to the size are formed. Especially, even if the depths of cells with a large shadow portion are adjusted to 5 to 6 µm, it can be hardly expected that the depths of cells with a small highlighted portion are adjusted 5 to 6 µm with certainty, because there is a high possibility that irregularities arise on the profiles or the bottom surfaces of the cells.

Thus, in order to obtain a gravure plate in which the depths of cells are 5 to 6 µm with certainty, an image is printed on alkaline glass and developed, and etching is then performed by fluoric acid, thereby forming cells having uniform depths with a fair degree of precision. It should be noted that this does not serve as gravure printing but serves as gravure offset printing in which printing is performed through a blanket roll.

As described above, conventionally, in order to color-print an image on glass for liquid crystal panels or color-print an image on a compact disc or the like, gravure offset printing or dry planographic printing plate offset printing has been employed, and gravure printing has not been employed.

In contrast, a conventional flexographic plate (a resin relief printing plate) is made by laminating a mask film on a photocurable resin, and irradiating the resultant with infrared light, followed by etching, or is made by forming a carbon black coating on the photocurable resin, applying a positive photosensitive film, printing a negative image and developing the image with a laser, and subsequently irradiating the resultant with infrared light, followed by etching.

However, with respect to a color filter for liquid crystal panels produced by the conventional printing methods, the sharpness of an image is low, the edge of a line image is distorted, a line image has irregularities, and the quality is notably inferior to a color filter for liquid crystal panels produced by a film method. Therefore, such color filters are merely applied to toys and the like, and are not at all applied to high-quality articles such as computer displays, and televisions.

The fact that the color filter for liquid crystal panels produced by gravure offset printing is poor in quality is presumably attributed to the following causes. In the gravure offset printing, when ink is transferred to a printing target such as glass from a blanket roll, printing pressure is applied somewhat. Since the printing pressure presses ink, the ink outline spreads outward or is disturbed. This is one of the causes of that the line and space value cannot be made small. Moreover, the ink to be transferred is not transferred to a blanket roll from a plate, and is not transferred to a printing target such as glass, from the blanket roll with a probability of 100%, respectively, resulting in that the ink is torn off. Therefore, the film thickness of the ink to be printed on the printing target such as glass is not uniform, and irregularities appear on the surface.

The research finding that the ink to be transferred can be transferred to the printing target such as glass with a probability of 100% is reported in an article. According to the article, ink was successfully transferred to the blanket roll from the plate with a probability of 100% by coating a 0.1 µm silicon rubber coating of a printing plate made of alkaline glass to give mold-release characteristics, and by irradiating a photocurable ink with light when the ink is applied to cells for half-drying the ink to thereby obtain ink which is difficult to tear. Further, the ink was successfully transferred to the glass for liquid crystal panels from the blanket roll with a probability of 100% by irradiating ink transferred to the blanket roll of a silicon derivative with light again before printing on the glass for liquid crystal panels for half-drying the ink to thereby obtain ink which is difficult to tear, and simultaneously, by applying an acrylic adhesive with a film thickness of 0.2 to 0.3 µm to the surface of the glass for liquid crystal panels.

However, in order to transfer ink to the glass for liquid crystal panels from the blanket roll with a probability of 100%, it is indispensable to ultraprecisely produce a plate and a printing apparatus. In other words, with the machine accuracy of a usual printing apparatus, it is inevitable that when transferring ink to the glass for liquid crystal panels from the blanket roll, printing pressure is applied and moreover fluctuates. It is extremely difficult to improve the machine accuracy so that the printing pressure does not generate at all and the printing pressure does not fluctuate at all.

If a printing apparatus is ultraprecisely produced so that a gap between the blanket roll and the glass for liquid crystal panels is completely matched with the film thickness of ink and moreover the gap size does not fluctuate during printing, the printing pressure is hardly applied and does not fluctuate. However, it is almost impossible to put such an apparatus in practical use.

This is because, when the gap between the blanket roll and the glass for liquid crystal panels is kept at 5.5 µm and when the ink with a film thickness of 6 µm adhering to the blanket roll is transferred to the glass for liquid crystal panels, printing pressure occurs so that the film thickness of the ink becomes 5.5 µm. When the blanket roll is rotated and simultaneously the glass for liquid crystal panels is directly acted in complete agreement with the speed of the blanket roll surface, it is extremely difficult not to vary the gap between the blanket roll and the glass for liquid crystal panels.

It is necessary to ultraprecisely produce the blanket roll so as to have a perfect circular shape or a perfect cylindrical shape and to directly act the glass for liquid crystal panels so that wave motion may not occur at all. When the diameter of the blanket roll is off-centered by 1 µm or the glass for liquid crystal panels approaches or goes away from the blanket roll by 1 µm, the film thickness of ink becomes 4.5 µm and the printing pressure fluctuates, or the gap between the blanket roll and the glass for liquid crystal panels becomes larger than 5.5 µm. In this case, the ink adhering to the blanket roll cannot be transferred to the glass for liquid crystal panels.

As is clear from the above, it is necessary to apply printing pressure and it is impossible to suppress the fluctuation of the printing pressure even if an ultraprecise gravure offset-printing apparatus is sought. Thus, since it is inevitable that the printing pressure is applied and the printing pressure fluctuates, even if ink can be transferred to the glass for liquid crystal panels from the blanket roll with a probability of 100% in experiments, it is presumably extremely difficult to put it to practical use.

In contrast, since a conventional flexographic plate (a resin relief printing plate) contains a photocurable resin, small dots are likely to break when formed into a columnar shape, and the brittleness of cured resin cannot be improved. Thus, a high precision plate cannot be provided.

In gravure printing, minute concave portions (gravure cells) according to platemaking information are formed in a gravure printing roll (a gravure cylinder) to produce a printing plate, and ink is filled in the gravure cells, thereby transferring an image to a printing target. In a general gravure printing roll, a copper-plated layer (a printing material) for forming a printing plate is formed on the surface of a hollow roll formed of metal such as aluminum or iron, or reinforced resin such as carbon fiber reinforced plastic (CFRP); a number of minute concave portions (gravure cells) are formed according to platemaking information in the copper-plated layer by etching; and then a hard chromium layer is formed by chromium plating for increasing the printing durability of a gravure printing roll to obtain a surface-reinforcing coating layer, whereby platemaking (production of a printing plate) is completed. However, since hexavalent chromium with high toxicity is used in the chromium plating, extra cost is required for maintaining safe operations and a problem of pollution arises. Therefore, in the present circumstances, development of a surface-reinforcing coating layer in place of a chromium layer is expected.

In contrast, with respect to production of a gravure printing roll (a gravure cylinder), a technology of forming a diamond-like carbon (DLC) on a copper-plated layer, in which cells are formed, and using the same as a surface-reinforcing coating layer is known (Patent Documents 1 to 3). However, there is a problem that the adhesion of the DLC layer with copper is weak, and thus the DLC layer is prone to separate. The applicants of this application have already suggested a technology of forming a rubber or resin layer on a hollow roll, forming a diamond-like carbon (DLC) film thereon, forming cells, and producing a gravure printing plate (Patent Documents 4 to 7).
Patent Document 1: JP 4-282296 A
Patent Document 2: JP 2002-172752 A
Patent Document 3: JP 2002-178653 A
Patent Document 4: JP 11-309950 A
Patent Document 5: JP 11-327124 A
Patent Document 6: JP 2000-15770 A
Patent Document 7: JP 2000-10300 A

### Disclosure of the Invention

### Problems to be Solved by the Invention

The present invention is contrived in view of the above-mentioned problems, and aims to provide a method of producing a printing plate, especially a gravure plate which allows direct gravure printing on a hard printing target without using a blanket roll owing to being provided with cushion properties, and which has cushion properties suitable for preferably gravure-printing on the rough surface of corrugated cardboard or the like, color-printing a matrix image for forming a color filter on glass for liquid crystal panels, or color-printing an image on a compact disk or the like.

### Means for Solving the Problems

In order to solve the above-mentioned problems, according to the present invention, a gravure printing roll having a cushion layer includes: a hollow roll having a cushion layer formed of rubber or resin with cushion properties on a surface of the hollow roll; a copper-plated layer formed on a surface of the cushion layer and having multiple gravure cells formed on a surface of the copper-plated layer; a metal layer formed on the surface of the copper-plated layer; a metal carbide layer of the metal formed on a surface of the metal layer; and a diamond-like carbon film covering a surface of the metal carbide layer.

According to the present invention, a method of producing a gravure printing roll having a cushion layer includes the steps of preparing a hollow roll having a cushion layer formed of rubber or resin with cushion properties on a surface of the hollow roll; forming a copper-plated layer on a surface of the cushion layer; forming multiple gravure cells on a surface of the copper-plated layer; forming a metal layer formed on the surface of the copper-plated layer; forming a metal carbide layer of the metal formed on a surface of the metal layer; and forming a diamond-like carbon film on a surface of the metal carbide layer.

As the metal carbide layer, a metal carbide gradient layer is preferred, and a composition ratio of carbon in the metal carbide gradient layer is set so that a proportion of carbon increases gradually in a direction of the diamond-like carbon film from the metal layer side.

It is preferred that a thickness of the copper-plated layer be 50 to 200 µm, a depth of the gravure cells be 5 to 150 µm, a thickness of the metal layer be 0.001 to 1 µm, preferably 0.001 to 0.1 µm, more preferably 0.001 to 0.05 µm, a thickness of the metal carbide layer be 0.1 to 1 µm, and a thickness of the diamond-like carbon film be 0.1 to 10 µm.

It is preferred that the metal layer, the metal carbide layer, preferably the metal carbide gradient layer, and the diamond-like carbon film be formed by sputtering, respectively.

It is preferred that the metal be capable of being carbonated and have high compatibility with copper.

It is preferred that the metal be one kind or at least two kinds of metals selected from the group consisting of tungsten (W), silicon (Si), titanium (Ti), chromium (Cr), tantalum (Ta), and zirconium (Zr).

It is preferred that the gravure cells be formed by etching or electronic platemaking.

### Effects of the Invention

According to the present invention, cushion properties can be given to a printing plate, and direct gravure printing on a hard printing target without using a blanket roll can be achieved. The present invention is suitable for color-printing a matrix image for forming a color filter on glass for liquid crystal panels or color-printing an image on a compact disk or the like. Moreover, according to the present invention, printing on the rough surface of corrugated cardboard or the like can be preferably performed. Further, according to the present invention, by the use of the diamond-like carbon (DLC) film as a surface-reinforcing coating layer, a chromium plating process can be omitted, which eliminates the necessity of using hexavalent chromium with high toxicity and incurs no extra cost for safe operations. Moreover, the present invention is completely free from a problem of pollution, and exhibits excellent effects that the diamond-like carbon (DLC) film has strength comparable to that of a chromium layer and is excellent in the printing durability.

### Brief Description of the Drawings

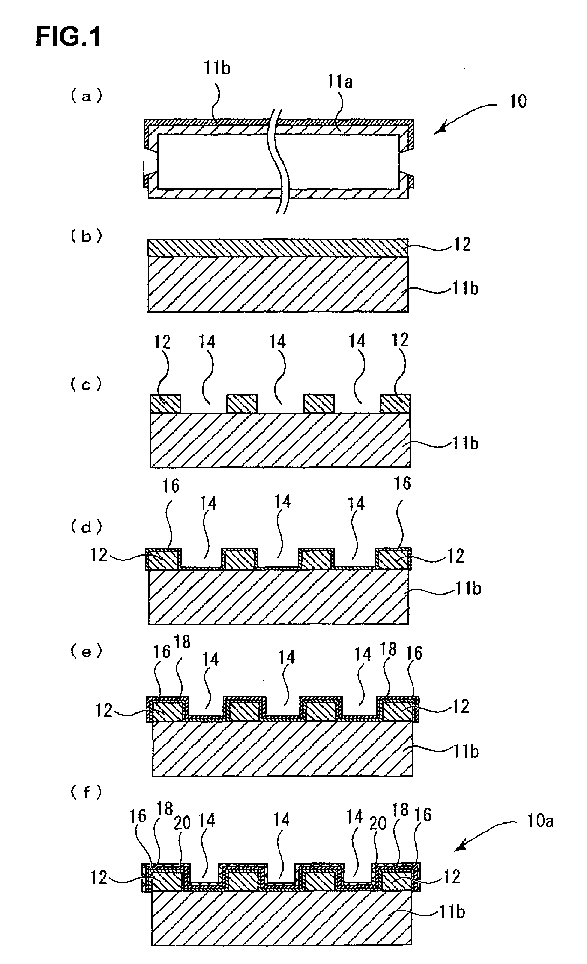

FIG. 1 is an explanatory diagram schematically illustrating a process of producing a gravure printing roll having a cushion layer of the present invention, in which (a) is an entire cross-sectional view of a plate base material provided with a cushion layer formed of rubber or resin with cushion properties on the surface of a hollow roll; (b) is a partial enlarged cross-sectional view illustrating a state in which a copper-plated layer is formed on the surface of the cushion layer; (c) is a partial enlarged cross-sectional view illustrating a state in which gravure cells are formed in the copper-plated layer; (d) is a partial enlarged cross-sectional view illustrating a state in which a tungsten carbide layer is formed on the surface of the copper-plated layer; (e) is a partial enlarged cross-sectional view illustrating a state in which a metal carbide layer is formed on the surface of the metal layer; and (f) is a partial enlarged cross-sectional view illustrating a state in which a diamond-like carbon (DLC) film covers the surface of the metal carbide layer.
FIG. 2 is a flowchart illustrating a method of producing a gravure printing roll of the present invention.
FIG. 3 is an enlarged cross-sectional view of main portions of the gravure printing roll having a cushion layer of the present invention.

### Description of Reference Symbols

10: a plate base metal (a rubber roll or the like), 10a: a gravure printing roll, 11a: a hollow roll, 11b: a cushion layer, 12: a copper-plated layer, 14: gravure cells, 16: a metal layer, 18: a metal carbide layer, preferably, a metal carbide gradient layer, 20: a diamond-like carbon (DLC) film.

### Best Mode for Carrying out the Invention

Hereinafter, an embodiment of the present invention will be described. Illustrated examples are shown for illustrative purposes. Therefore, it is needless to say that they can be modified variously as long as they do not extend beyond the technical idea of the present invention.

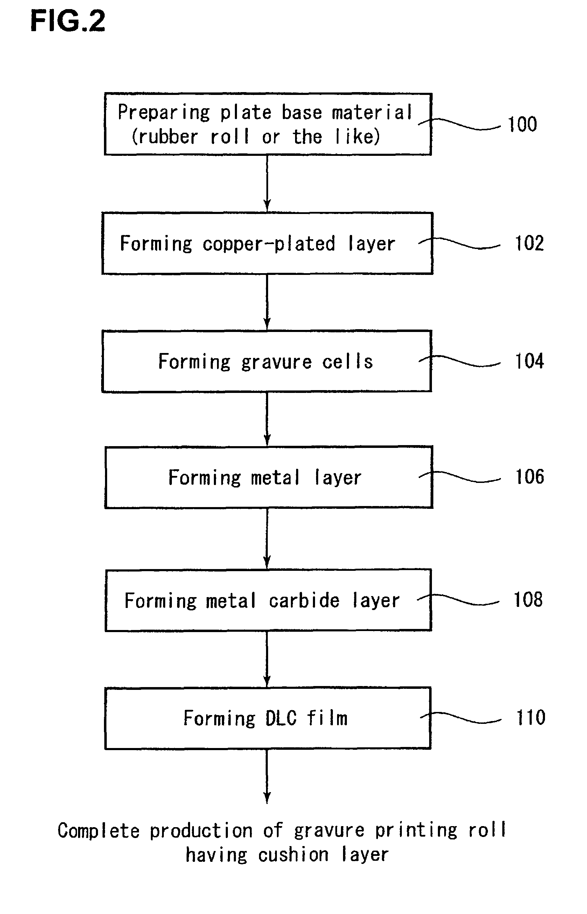

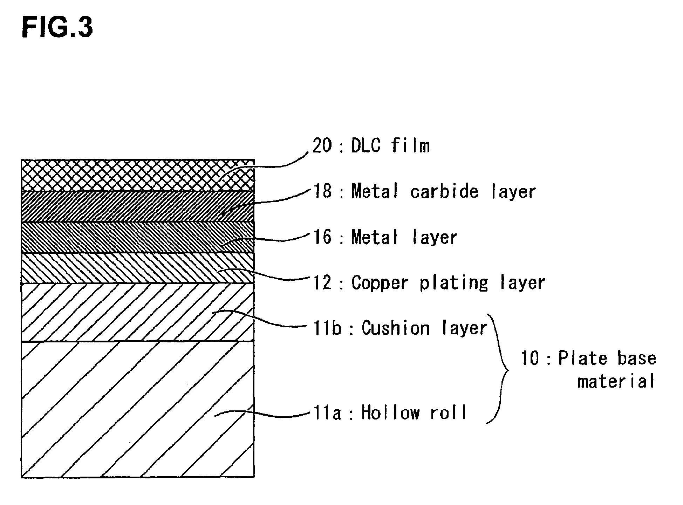

FIG. 1 is an explanatory diagram schematically illustrating a process of producing a gravure printing roll having a cushion layer of the present invention, in which the part (a) is an entire cross-sectional view of a plate base material provided with a cushion layer formed of rubber or resin with cushion properties on the surface of a hollow roll; the part (b) is a partial enlarged cross-sectional view illustrating a state in which a copper-plated layer is formed on the surface of the cushion layer; the part (c) is a partial enlarged cross-sectional view illustrating a state in which gravure cells are formed in the copper-plated layer; the part (d) is a partial enlarged cross-sectional view illustrating a state in which a tungsten carbide layer is formed on the surface of the copper-plated layer; the part (e) is a partial enlarged cross-sectional view illustrating a state in which a metal carbide layer is formed on the surface of the metal layer; and the part (f) is a partial enlarged cross-sectional view illustrating a state in which a diamond-like carbon (DLC) film covers the surface of the metal carbide layer. FIG. 2 is a flowchart illustrating a method of producing a gravure printing roll of the present invention. FIG. 3 is an enlarged cross-sectional view of main portions of the gravure printing roll having a cushion layer of the present invention.

The method of the present invention will be described with reference to FIGS. 1 to 3. In FIGS. 1(a) and 3, reference numeral 10 denotes a plate base metal, and metal with a cushion layer 11b on the surface of the hollow roll 11a formed of aluminum, iron, or reinforced resin, such as carbon fiber reinforced plastics (CFRP) is used for the plate base metal (Step 100 of FIG. 2). The cushion layer 11b is formed of rubber or resin with cushion properties. The cushion layer 11b is of a sheet-like material which has a uniform thickness of about 1 mm to 10 cm and a high degree of surface smoothness. The sheet-like material is wrapped around the hollow roll 11a, and firmly adhered thereto so that a gap may not be formed in a joint portion, followed by precision cylindrical grinding and mirror polishing. A copper-plated layer 12 is formed on the surface of the cushion layer 11b by copper plating (Step 102 of FIG. 2).

On the surface of the copper-plated layer 12, a number of minute concave portions (gravure cells) 14 are formed (Step 104 of FIG. 2). As a method of forming the gravure cells 14, a known method can be used, such as an etching method where a sensitizing solution is coated on a plate body surface to perform direct burning, followed by etching, thereby forming the gravure cells 14, or an electronic platemaking method where a diamond platemaking needle is mechanically operated with a digital signal to make the gravure cells 14 on the copper surface. It is preferable to use the etching method.

Next, a metal layer 16 is formed on the surface of the copper-plated layer 12 (including the gravure cells 14) with the gravure cells 14 formed thereon (Step 106 of FIG. 2). Further, a metal carbide layer of the metal, preferably, a metal carbide gradient layer 18 is formed on the surface of the metal layer 16 (Step 108 of FIG. 2). As a method of forming the metal layer 16 and the metal carbide layer, preferably, the metal carbide gradient layer 18, known methods such as a sputtering method, a vacuum deposition method (an electron beam method), an ion plating method, a molecular beam epitaxy method (MBE), a laser abrasion method, an ion assist film-formation method, and a plasma CVD method can be applied. The sputtering method is preferable.

As the metal, a metal capable of being carbonated and having high compatibility with copper is preferable. As such a metal, it is possible to use tungsten (W), silicon (Si), titanium (Ti), chromium (Cr), tantalum (Ta), zirconium (Zr), or the like.

As the metal in the metal carbide layer, preferably, the metal carbide gradient layer 18, the same metal as that of the metal layer 16 is used. The composition ratio of carbon in the metal carbide gradient layer 18 is set so that the proportion of carbon increases gradually from the metal layer 16 side in the direction of a diamond-like carbon (DLC) film 20 described later. That is, film formation is performed so that the composition ratio of carbon increases gradually in a proportion from 0% (by stages or by non-stages) to finally reach about 100%.

In this case, as a method of adjusting the composition ratio of carbon in the metal carbide layer, preferably, the metal carbide gradient layer 18, a known method may be used. For example, the metal carbide layer (i.e., the metal carbide gradient layer 18) can be formed, in which the composition ratios of carbon and metal are changed so that the proportion of carbon in the metal carbide layer 18 increases gradually in stages or in non-stages in the direction of the diamond-like carbon (DLC) film 20 from the copper-plated layer 12 side, for example, by a sputtering method where the injection amount of hydrocarbon gas such as methane gas, ethane gas, propane gas, butane gas, or acetylene gas increases gradually by stages or by non-stages in an argon gas atmosphere, using a solid metal target.

By adjusting the proportion of carbon in the metal carbide layer 18, the adhesion of the metal carbide layer 18 with respect to both the metal layer 16 and the diamond-like carbon (DLC) film 20 can be enhanced. Further, if the injection amount of hydrocarbon gas is set to be constant, a metal carbide layer in which the composition ratios of carbon and metal are set to be constant can be formed, and the metal carbide layer thus obtained is allowed to perform a similar function to that of the metal carbide gradient layer.

Then, on the surface of the metal carbide layer, preferably, the metal carbide gradient layer 18, the diamond-like carbon (DLC) film 20 is formed so as to cover the surface of the metal carbide layer (Step 110 of FIG. 2). As a method of forming the diamond-like carbon (DLC) film 20, in the same way as in the formation of the metal layer 16 and the metal carbide layer, preferably, the metal carbide gradient layer 18, a known method such as a sputtering method, a vacuum deposition method (an electron beam method), an ion plating method, a molecular beam epitaxy method (MBE), a laser abrasion method, an ion assist film formation method, or a plasma CVD method can be applied. The sputtering method is preferable.

The above-mentioned diamond-like carbon (DLC) film 20 is covered, and is allowed to function as a surface-reinforcing coating layer, whereby a gravure printing roll 10a excellent in printing durability without toxicity and any possibility of the occurrence of pollution can be obtained.

Herein, according to the sputtering method, ions are allowed to strike a material (a target material) desired to be a thin film, the material is sputtered, and the sputtered material is deposited on a substrate to produce a thin film. The sputtering method is characterized, for example, in that no particular limitations are imposed on a target material and a thin film can be produced with good reproducibility in a large area.

According to the vacuum deposition method (the electron beam method), a material desired to be a thin film is heated to be evaporated by the irradiation of electron beams, and the evaporated material is adhered (is deposited) on a substrate to produce a thin film. The vacuum deposition method is characterized, for example, in that a film formation speed is high, and the damage to a substrate is small.

According to the ion plating method, a material desired to be a thin film is evaporated and ionized with a radio frequency (RF) (RF ion plating) or arc (arc ion plating), and deposited on a substrate to produce a thin film. The ion plating method is characterized, for example, in that a film formation speed is high, and adhesion strength is large.

The molecular beam epitaxy method is a method of evaporating a raw material in an ultrasonic vacuum, and supplying the raw material to a heated substrate to form a thin film.

The laser abrasion method is a method of allowing a laser pulse increased in density to be incident upon a target to allow ions to be released, thereby forming a thin film on an opposed substrate.

The ion assist film formation is a method of setting an evaporation source and an ion source in a vacuum container, and forming a film, using ions, supplementarily.

The plasma CVD is a method of decomposing a material gas using the excitation of plasma, and allowing the material gas to be deposited by reaction on a substrate, for the purpose of forming a thin film at lower temperature when performing the CVD method under a reduced pressure.

### Example

The present invention will be described more specifically by way of the following examples. It should be appreciated that these examples are shown merely for an illustrative purpose and should not be interpreted in a limiting manner.

### (Example 1)

The following copper-plated layer was formed and etched by using Boomerang Line (a gravure printing roll producing machine, manufactured by Think Laboratory Co., Ltd.). First, a 5cm thick silicone rubber layer was wrapped around the surface of an aluminum hollow roll having a circumference of 600 mm and a length of 1,100 mm, thereby preparing a plate base material with a cushion layer. The plate base material was set in a plating tank, an anode chamber was brought up to a position 20 mm away from the hollow roll by an automatic slide apparatus using a computer system, and a plating liquid was overflowed to submerge the entire hollow roll so as to form a copper-plated layer having a thickness of 80 µm at 18 A/dm² and 6.0 V The plating time was 20 minutes, no bumps and pits were formed on the plating surface, and a uniform copper-plated layer was obtained. The surface of this copper-plated layer was polished with a 4H polishing machine (manufactured by Think laboratory Co., Ltd.) for 12 minutes to make the surface of the copper-plated layer uniform.

A photosensitive film (thermal resist: TSER-2104E4) was formed on the formed copper-plated layer with a coater (a fountain coater) and dried. When the thickness of the obtained photosensitive film was measured with a film thickness meter (F20 manufactured by FILMETRICS Co., Ltd., and marketed by Matsushita Techno Trading Co., Ltd.), it was 4 µm. Then, an image was exposed to a laser beam and developed. The laser exposure was carried out with Laser Stream FX for 5 minutes/m²/10W to form a predetermined pattern. The development was carried out by using a TLD developer (manufactured by Think Laboratory Co., Ltd.) at a developer dilution rate of 1:7 (undiluted solution : water) and 24°C for 60 seconds to form a predetermined pattern. This pattern was dried (by burning) to form a resist image.

Further, cylinder etching was carried out to make an image of gravure cells, and then the resist image was removed to form a printing plate. At this point, a cylinder was produced by setting the depth of the gravure cells to 5 µm. The etching was carried out by spraying at a copper concentration of 60 g/l, a hydrochloric acid concentration of 35 g/l, and a temperature of 37°C for a time of 70 seconds.

On an upper surface of the copper-plated layer with the gravure cells formed thereon, a tungsten (W) layer was formed by sputtering. The sputtering conditions were as follows. A tungsten (W) sample: a solid tungsten target, an atmosphere: an argon gas atmosphere, a film formation temperature: 200°C to 300°C, a film formation time: 60 minutes, and a film formation thickness: 0.03 µm.

Next, a tungsten carbide layer was formed on the upper surface of the tungsten layer (W). The sputtering conditions were as follows. A tungsten (W) sample: a solid tungsten target, an atmosphere: hydrocarbon gas was increased gradually in an argon gas atmosphere, a film formation temperature: 200°C to 300°C, a film formation time: 60 minutes, and a film formation thickness: 0.1 µm.

Further, on an upper surface of tungsten carbide layer, a diamond-like carbon (DLC) film was formed so as to cover the upper surface of the tungsten carbide layer by sputtering. The sputtering conditions were as follows. A DLC sample: a solid carbon target, an atmosphere: an argon gas atmosphere, a film formation temperature: 200°C to 300°C, a film formation time: 150 minutes, and a film formation thickness: 1 µm. Thus, a gravure printing roll (a gravure cylinder) was completed.

Subsequently, a printing test (printing rate: 120 m/min) was conducted on the obtained gravure cylinder by using cyanide ink Zahn cup viscosity of 18 seconds (Super Ramipure Indigo 800PR-5 aqueous ink, manufactured by SAKATA INX CORPORATION) as printing ink and OPP film (Oriented Polypropylene Film: biaxially oriented polypropylene film). The obtained printed material had no fogging, and printing could be made up to a length of 50,000 m. The accuracy of the pattern did not change. There was no problem with the adhesion of the DLC film to the etched copper-plated cylinder. Gradation from the highlighted portion to the shadow portion of the gravure cylinder of the present invention did not differ from that of a chromium plated gravure cylinder produced in accordance with a commonly used method. Accordingly, it is judged that there was no problem with ink transferability. As a result, it was confirmed that the diamond-like carbon (DLC) film has performance equivalent to that of a conventional chromium layer and can be used as a substitute for the chromium layer satisfactorily.

### (Example 2)

Following the procedure of Example 1, a cylinder in which the depths of gravure cells were adjusted to 5 µm was produced. Following the procedure of Example 1 except using silicon (Si) sample in place of the tungsten (W) sample for the cylinder, a gravure printing roll having a cushion layer was obtained, and a printing test was similarly performed. Then, it was revealed that the obtained gravure printing roll having a cushion layer had equivalent printing performances, i.e., the printing roll is similarly free from plate fogging and the like. The results confirmed that the diamond-like carbon (DLC) film had performance comparable to that of the conventional chromium layer, and was satisfactorily used as a substitute for a chromium layer. It should be noted that the same experiment was performed using titanium (Ti) and chromium (Cr) as a metal sample, and it was confirmed that the same results were obtained.

## Claims

1. A gravure printing roll having a cushion layer, comprising:
a hollow roll having a cushion layer formed of rubber or resin with cushion properties on a surface of the hollow roll;
a copper-plated layer formed on a surface of the cushion layer and having multiple gravure cells formed on a surface of the copper-plated layer;
a metal layer formed on the surface of the copper-plated layer;
a metal carbide layer of the metal formed on a surface of the metal layer; and
a diamond-like carbon film covering a surface of the metal carbide layer.

2. A gravure printing roll having a cushion layer according to claim 1, wherein the metal carbide layer is a metal carbide gradient layer, and a composition ratio of carbon in the metal carbide gradient layer is set so that a proportion of carbon increases gradually in a direction of the diamond-like carbon film from the metal layer side.

3. A gravure printing roll having a cushion layer according to claim 1 or 2, wherein a thickness of the copper-plated layer is 50 to 200 µm, a depth of the gravure cells is 5 to 150 µm, a thickness of the metal layer is 0.001 to 1 µm, a thickness of the metal carbide layer is 0.1 to 1 µm, and a thickness of the diamond-like carbon film is 0.1 to 10 µm.

4. A gravure printing roll according to any one of claims 1 to 3, wherein the metal is capable of being carbonated and has high compatibility with copper.

5. A gravure printing roll having a cushion layer according to any one of claims 1 to 4, wherein the metal is one kind or at least two kinds of metals selected from the group consisting of tungsten (W), silicon (Si), titanium (Ti), chromium (Cr), tantalum (Ta), and zirconium (Zr).

6. A method of producing a gravure printing roll having a cushion layer, comprising the steps of:
preparing a hollow roll having a cushion layer formed of rubber or resin with cushion properties on a surface of the hollow roll;
forming a copper-plated layer on a surface of the cushion layer;
forming multiple gravure cells on a surface of the copper-plated layer;
forming a metal layer formed on the surface of the copper-plated layer;
forming a metal carbide layer of the metal formed on a surface of the metal layer; and
forming a diamond-like carbon film on a surface of the metal carbide layer.

7. A method of producing a gravure printing roll having a cushion layer according to claim 6, wherein the metal carbide layer is a metal carbide gradient layer, and a composition ratio of carbon in the metal carbide gradient layer is set so that a proportion of carbon increases gradually in a direction of the diamond-like carbon film from the metal layer side.

8. A method of producing a gravure printing roll having a cushion layer according to claim 6 or 7, wherein a thickness of the copper-plated layer is 50 to 200 µm, a depth of the gravure cells is 5 to 150 µm, a thickness of the metal layer is 0.001 to 1 µm, a thickness of the metal carbide layer is 0.1 to 1 µm, and a thickness of the diamond-like carbon film is 0.1 to 10 µm.

9. A method of producing a gravure printing roll having a cushion layer according to any one of claims 6 to 8, wherein the metal layer, the metal carbide layer, and the diamond-like carbon film are formed by sputtering, respectively.

10. A method of producing a gravure printing roll having a cushion layer according to any one of claims 6 to 9, wherein the metal is capable of being carbonated and has high compatibility with copper.

11. A method of producing a gravure printing roll having a cushion layer according to any one of claims 6 to 10, wherein the metal is one or at least two kinds of metals selected from the group consisting of tungsten (W), silicon (Si), titanium (Ti), chromium (Cr), tantalum (Ta), and zirconium (Zr).

12. A method of producing a gravure printing roll having a cushion layer according to any one of claims 6 to 11, wherein the gravure cells are formed by etching or electronic platemaking.
